# EUROPEAN PATENT SPECIFICATION

(11) **EP 4 191 624 B1**
(45) Date of publication and mention of the grant of the patent: **15.04.2026**
(21) Application number: 22188103.0
(22) Date of filing: 01.08.2022
(51) Int. Cl.: H01G 4/12, H01G 4/40, H01G 4/33, H10D 1/68, H01G 4/20

(54) **DIELECTRIC THIN FILM COMPRISING PEROVSKITE MATERIAL, CAPACITOR INCLUDING THE DIELECTRIC THIN FILM, AND ELECTRONIC DEVICE INCLUDING THE CAPACITOR**
DIELEKTRISCHER DÜNNFILM MIT PEROWSKITMATERIAL, KONDENSATOR MIT DEM DIELEKTRISCHEN DÜNNFILM UND ELEKTRONISCHE VORRICHTUNG MIT DIESEM KONDENSATOR
FILM MINCE DIÉLECTRIQUE COMPRENANT UN MATÉRIAU PEROVSKITE, CONDENSATEUR COMPRENANT LE FILM MINCE DIÉLECTRIQUE ET DISPOSITIF ÉLECTRONIQUE COMPRENANT LE CONDENSATEUR

(30) Priority: 02.12.2021 US 202163285246 P; 12.01.2022 KR 20220004771
(43) Date of publication of application: 07.06.2023
(73) Proprietor: Samsung Electronics Co., Ltd., Suwon-si, Gyeonggi-do 16677 (KR); Cornell University, Ithaca, New York 14850 (US)
(72) Inventor: LEE, Kiyoung, Suwon-si 16678 (KR); SCHLOM, Darrell G, Ithaca, 14850 (US); BARONE, Matthew R, Ithaca, 14850 (US); JEONG, Myoungho, Suwon-si 16678 (KR)
(74) Representative: Elkington and Fife LLP

(56) References cited:
- US-B2- 11 133 179
- CHEN L-S ET AL: "DIELECTRIC PROPERTIES OF INTERNAL CAPACITORS IN CO-FIRED CERAMIC SUBSTRATES", JAPANESE JOURNAL OF APPLIED PHYSICS, JAPAN SOCIETY OF APPLIED PHYSICS, JP, vol. 39, no. 5A, PART 01, 8 February 2000 (2000-02-08), pages 2675 - 2679, XP001014980, ISSN: 0021-4922, DOI: 10.1143/JJAP.39.2675
- RESHAK ALI HUSSAIN ET AL: "Electronic Band Structure and Optical Properties of Sr n +1 Ti n O 3 n +1 Ruddlesden-Popper Homologous Series", JAPANESE JOURNAL OF APPLIED PHYSICS, vol. 47, no. 7, 11 July 2008 (2008-07-11), JP, pages 5516 - 5520, XP093004397, ISSN: 0021-4922, DOI: 10.1143/JJAP.47.5516

## Description

### BACKGROUND

The disclosure relates to a dielectric thin film comprising a perovskite material, a capacitor comprising the dielectric thin film, and an electronic device comprising the capacitor.

Recently, as the trend of high functionality, high efficiency, miniaturization, and weight reduction of electronic devices is rapidly progressing, characteristics such as miniaturization and high performance of electronic components such as capacitors used in electronic devices have rapidly improved.

According to the scale down of an electronic devices, improvement of the permittivity of a dielectric thin film included in. e.g., capacitors, semiconductor devices, and/or the like have been requested to obtain high capacitance in the same area. According to the trend towards the integration of electronic components, not only material properties have been improved, but also structure improvement through process capability enhancement has been achieved. Nevertheless, in a situation where the improvement of the physical structure of electronic component has reached its limit, the development of new techniques and materials is required to obtain physical properties beyond those of the previously used material.

Accordingly, as a material with high permittivity to replace a silicon oxide, an aluminum oxide, and/or the like, which have been used as dielectric thin films for capacitors, research on binary oxides such as a hafnium dioxide (HfO₂), a zirconium oxide (ZrO₂), a tantalum oxide (Ta₂O₅), and a titanium dioxide (TiO₂), and perovskite materials such as strontium titanate (SrTiO₃), (Ba, Sr)TiO₃, etc. is in progress. In particular, research to utilize a perovskite material exhibiting relatively high permittivity as a dielectric thin film has been actively conducted.

A dielectric loss is generated in a process of operating a capacitor comprising a dielectric thin film. The higher a dissipation factor of a dielectric material, the greater the dielectric loss of the dielectric material. Although the perovskite material shows high permittivity, the perovskite material does not tend to have a sufficiently low dissipation factor to be applied to a dielectric thin film of a high performance capacitor.

### SUMMARY

The invention is defined according to the features defined in independent claim 1. Further embodiments are outlined in the dependent claims.

Provided is a dielectric thin film comprising a perovskite material having a low dissipation factor and having a low dielectric loss, a capacitor comprising the dielectric thin film, and an electronic device comprising the capacitor.

Provided is a dielectric thin film comprising a perovskite material having a low dielectric loss by having a stack structure in which a rocksalt layer is formed on a perovskite material layer, a capacitor comprising the dielectric thin film, and an electronic device comprising the capacitor.

Additional aspects will be set forth in part in the description which follows and, in part, will be apparent from the description, or may be learned by practice of the presented embodiments of the disclosure.

According to the invention, a dielectric thin film includes a stack structure including a perovskite material layer including at least two Group II elements and a rocksalt layer on the perovskite material layer and including at least two Group II elements.

A first content ratio of the at least two Group II elements included in the perovskite material layer is the same as a second content ratio of the at least two Group II elements included in the rocksalt layer are identical to each other.

The dissipation factor of the dielectric thin film may be 0.05 or less.

The lowest energy level in a conduction band of the rocksalt layer may be greater than a lowest energy level in a conduction band of the perovskite material layer.

The rocksalt layer may have the thickness of a rocksalt crystal structure unit cell.

The perovskite material layer may include a material expressed by a chemical formula ((A, A')BX₃)ₘ, in which A and A' are different Group II elements, B is a Group IV element, X is an oxygen element O, and m is a natural number.

The rocksalt layer may include a material expressed by a chemical formula (C, C')X, in which C and C' may be different Group II elements.

Also, m may be a natural number greater than or equal to 2.

US11133179B2 relates to a thin-film structure including a support layer and a dielectric layer on the support layer. The support layer includes a material having a lattice constant. The dielectric layer includes a compound having a Ruddlesden-Popper phase (An+1BnX3n+1). where A and B each independently include a cation, X is an anion, and n is a natural number. The lattice constant of the material of the support layer may be less than a lattice constant of the compound.

"Dielectric properties of internal capacitors in co-fired ceramic substrates" by L.S. Chen et al. (Jpn. J. Appl. Phys., 2000) relates to the dielectric properties of barium titanate perovskites for use in internal ceramic capacitors. LiF additives are introduced to the perovskite during the sintering process to promote sintering and lower the sintering temperature for use in low firing systems.

A and C may be the same Group II element, A' and C' may be the same Group II element, and the first content ratio may be represented by A/A' and the second content ratio may be presented by C/C'.

The dielectric thin film may comprise a plurality of the stack structure.

The plurality of stack structures may be sequentially stacked such that the perovskite material layers and the rocksalt layers alternate.

The perovskite material layer may include a first lattice constant; the rocksalt layer may include a second lattice constant, and the first lattice constant may be greater than the second lattice constant.

According to another aspect of the disclosure, a capacitor includes a lower electrode, an upper electrode, and the dielectric thin film isolating the upper electrode from the lower electrode.

At least one of the lower electrode or the upper electrode may include at least one of SrVO₃, SrMnO₃, SrCrO₃, SrFeO₃, SrCoO₃, SrRuO₃, SrMoO₃, SrIrO₃, SrNbO₃, or SrCoO₃.

According to an aspect of the disclosure, an electronic device includes a transistor and the capacitor electrically connected to the transistor.

The transistor may include a semiconductor substrate including a source region, a drain region, and a channel region between the source region and the drain region, and a gate stack a gate electrode on the channel region and a gate insulating layer isolating the gate electrode from the channel region.

The electronic device may further include a memory unit including the capacitor and the transistor, and a control unit electrically connected to the memory unit and configured to control the memory unit.

### BRIEF DESCRIPTION OF THE DRAWINGS

The above and other aspects, features, and advantages of certain embodiments of the disclosure will be more apparent from the following description taken in conjunction with the accompanying drawings, in which:
FIG. 1 is a schematic diagram of an example configuration of a dielectric thin film according to some example embodiments;
FIG. 2 is a schematic diagram of an example configuration of a dielectric thin film according to some example embodiments;
FIG. 3 is an electron microscope image of a cross section of the dielectric thin film of FIG. 2;
FIG. 4 schematically illustrates the structure of a perovskite material;
FIG. 5 schematically illustrates the structure of rocksalt;
FIG. 6 illustrates a state of stacking a plurality of perovskite material layers and a plurality of rocksalt layers, which are included in the dielectric thin film of FIG. 2;
FIG. 7 is an enlarged view of a region a1 of FIG. 6;
FIG. 8 is an electron microscope image of a cross section of a structure in which the dielectric thin film of FIG. 2 is provided on an electrode;
FIG. 9 is an enlarged view of a region a2 of FIG. 8;
FIG. 10 is a view for explaining the bandgap energy of the dielectric thin film of FIG. 2;
FIG. 11 is a graph showing a change of a dissipation factor of the dielectric thin film of FIG. 2 according to an input AC signal;
FIG. 12 is a graph showing changes of a dielectric constant and a dissipation factor of the dielectric thin film of FIG. 2 according to an input DC signal;
FIG. 13 is a schematic view of an example configuration of a capacitor according to some example embodiments;
FIG. 14 is a schematic view of an example configuration of a capacitor according to some example embodiments;
FIG. 15 is a circuit diagram showing a schematic circuit configuration and operation of an electronic device employing capacitors according to some example embodiments;
FIG. 16 is a schematic view of an electronic device according to some example embodiments;
FIG. 17 is a schematic view of an electronic device according to some example embodiments; and
FIGS. 18 and 19 are schematic block diagrams showing the concept of a device architecture to be applied to an apparatus, according to some example embodiments.

### DETAILED DESCRIPTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list.

Throughout the drawings, the size or thickness of each constituent element illustrated in the drawings may be exaggerated for convenience of explanation and clarity.

In the following description, when a constituent element is disposed "above" or "on" to another constituent element, the constituent element may be only directly on the other constituent element or above the other constituent elements in a noncontact manner. The expression of singularity in the specification includes the expression of plurality unless clearly specified otherwise in context.

Terms such as "first" and "second" are used herein merely to describe a variety of constituent elements, but the constituent elements are not limited by the terms. Such terms are used only for the purpose of distinguishing one constituent element from another constituent element.

When the terms "about" or "substantially" are used in this specification in connection with a numerical value, it is intended that the associated numerical value includes a manufacturing or operational tolerance (e.g., ±10%) around the stated numerical value. Moreover, when the words "generally" and "substantially" are used in connection with geometric shapes, it is intended that precision of the geometric shape is not required but that latitude for the shape is within the scope of the disclosure. Further, regardless of whether numerical values or shapes are modified as "about" or "substantially," it will be understood that these values and shapes should be construed as including a manufacturing or operational tolerance (e.g., ±10%) around the stated numerical values or shapes.

Throughout the specification, it will be further understood that the terms "comprises" and/or "comprising" used herein specify the presence of stated features or components, but do not preclude the presence or addition of one or more other features or components.

The use of the terms "a" and "an" and "the" and similar referents in the context of describing the disclosure are to be construed to cover both the singular and the plural.

A perovskite material collectively refers to a compound having a first cation located at (0, 0, 0), a second cation located at (1/2, 1/2, 1/2), and an anion located at (1/2, 1/2, 0), in a unit cell. For example, a perovskite material may be a material with a crystalline structure with the lattice structure and/or symmetrical structure of perovskite (CaTiO₃). It will be interpreted that the perovskite material includes not only an ideal symmetrical structure of CaTiO₃, but also a twisted structure having less symmetricity than that of the ideal symmetrical structure.

A rocksalt may be a material with a crystalline structure with the lattice structure and/or symmetrical structure of rock salt (NaCl). For example, herein, rocksalt collectively may refer to a compound having a cation located at (0, 0, 0), and an anion located at (1/2, 1/2, 0), in a unit cell. A plurality of rocksalt unit cells may be aggregated to be represented by a face-centered cubic (FCC) halite like crystal structure. It will be interpreted that the rocksalt includes not only an ideal symmetrical structure of NaCl, but also a twisted structure having less symmetricity than that of the ideal symmetrical structure.

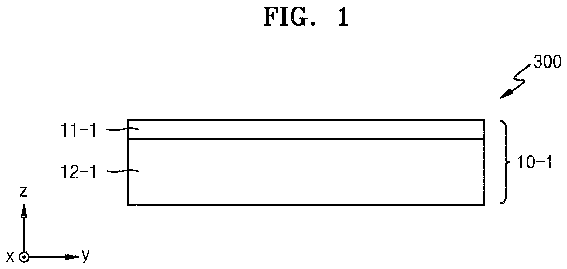

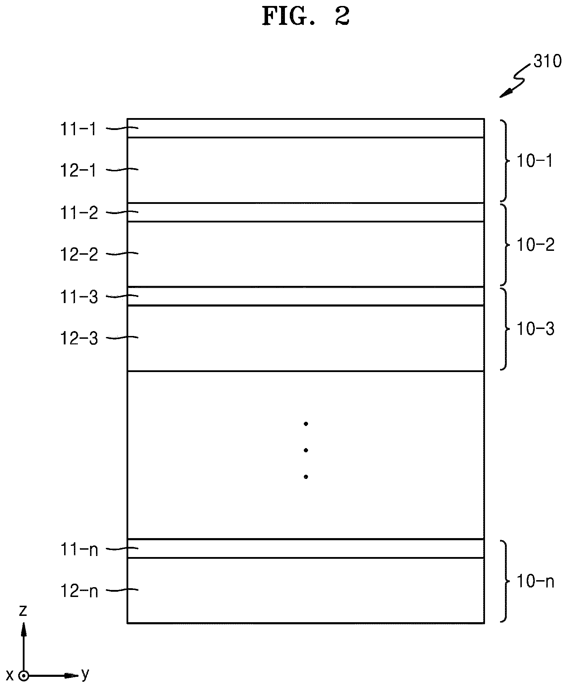

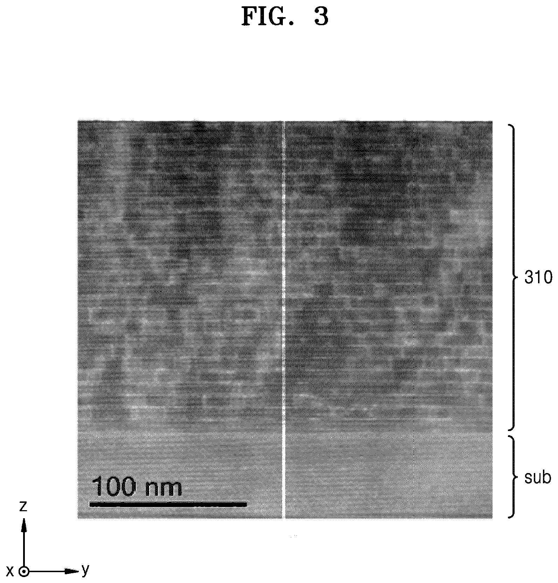

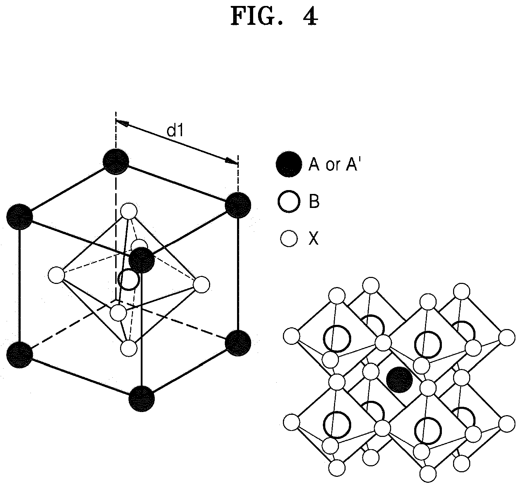

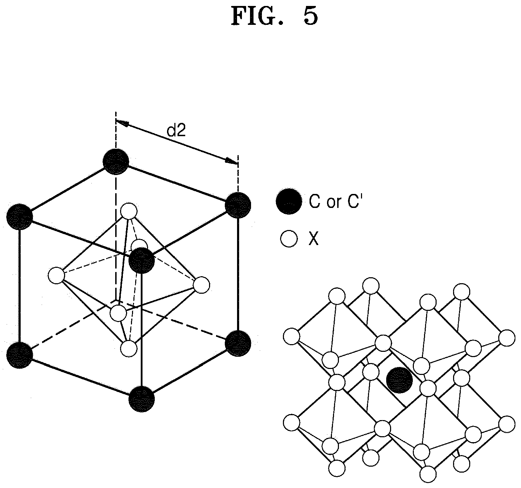

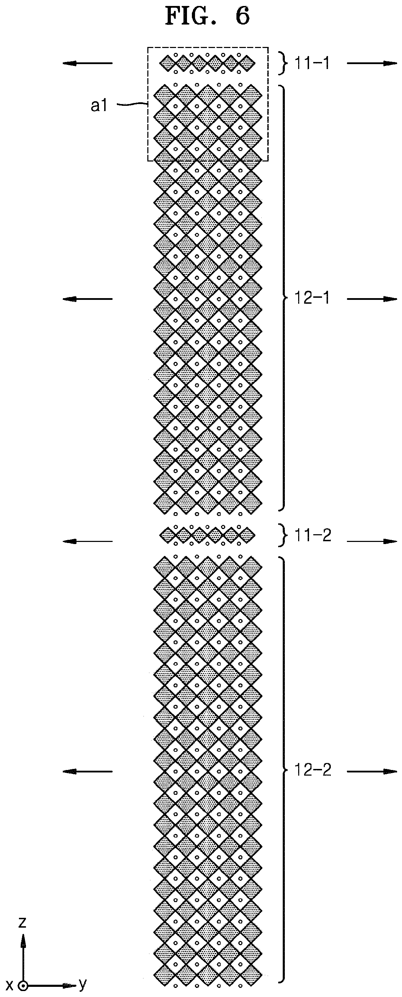

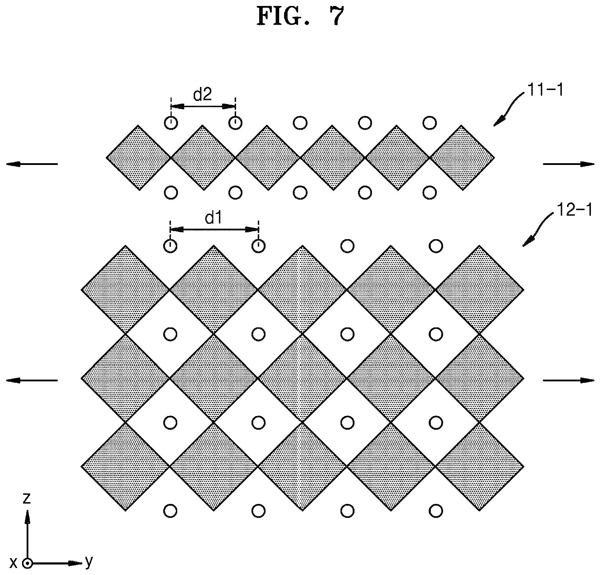

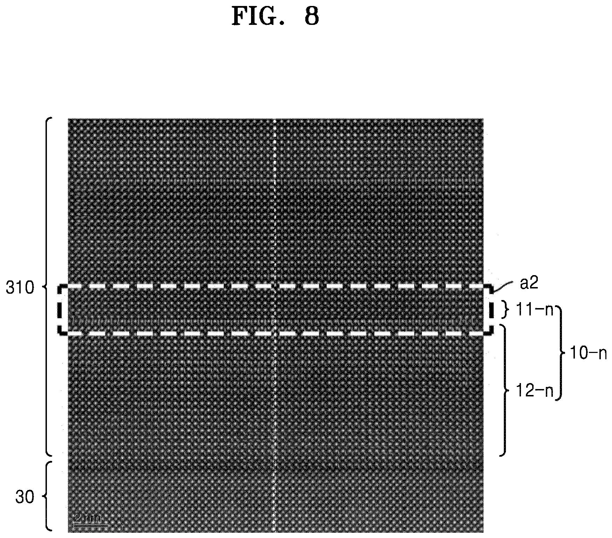

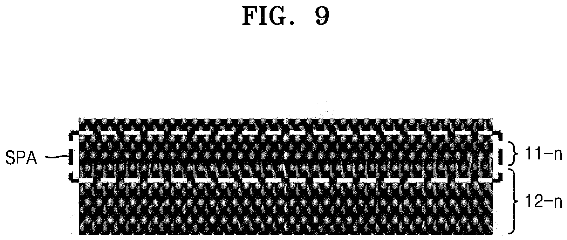

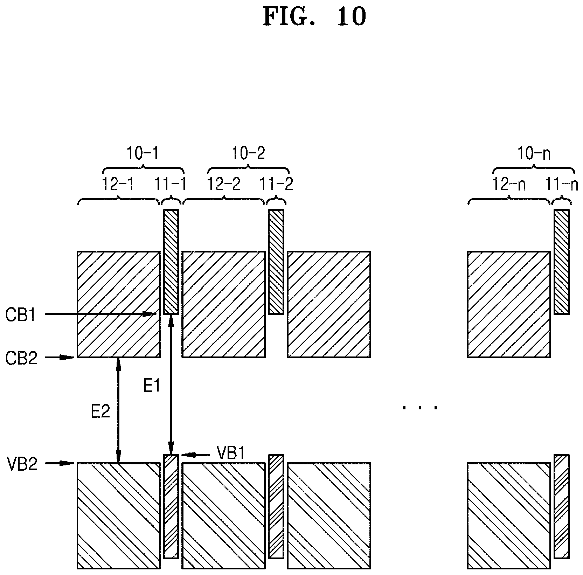

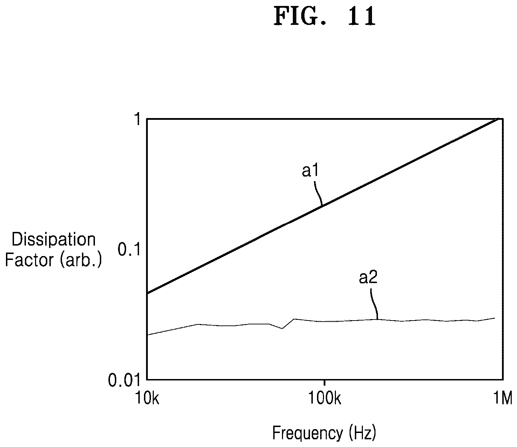

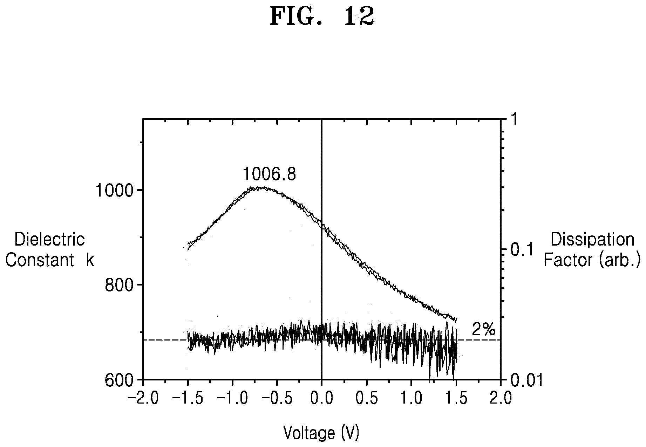

FIG. 1 is a schematic diagram of an example configuration of a dielectric thin film 300 according to some example embodiments; FIG. 2 is a schematic diagram of an example configuration of a dielectric thin film 310 according to some example embodiments; FIG. 3 is an electron microscope image of a cross section of the dielectric thin film 310 of FIG. 2; FIG. 4 schematically illustrates the structure of a perovskite material; FIG. 5 schematically illustrates the structure of rocksalt; FIG. 6 illustrates a state of stacking a plurality of perovskite material layers 12-1 and 12-2 and a plurality of rocksalt layers 11-1 and 11-2, which are included in the dielectric thin film 310 of FIG. 2; FIG. 7 is an enlarged view of a region a1 of FIG. 6; FIG. 8 is an electron microscope image of a cross section of a structure in which the dielectric thin film 310 of FIG. 2 is provided on an electrode 30; FIG. 9 is an enlarged view of a region a2 of FIG. 8; FIG. 10 is a view for explaining the bandgap energy of the dielectric thin film 310 of FIG. 2; FIG. 11 is a graph showing a change of a dissipation factor of the dielectric thin film 310 of FIG. 2 according to an input AC signal; FIG. 12 is a graph showing changes of a dielectric constant and a dissipation factor of the dielectric thin film 310 of FIG. 2 according to an input DC signal.

Referring to FIG. 1, the dielectric thin film 300 according to some example embodiments may have a stack structure 10-1 including a perovskite material layer 12-1 and a rocksalt layer 11-1 formed on the perovskite material layer 12-1. Each of the perovskite material layer 12-1 and the rocksalt layer 11-1 may have a layer structure expanding on a two-dimensional plane (e.g., x-y plane), and the rocksalt layer 11-1 may be stacked on the perovskite material layer 12-1 in a vertical direction (e.g., in the z-direction). As described below, as the rocksalt layer 11-1 is stacked on the perovskite material layer 12-1, the dielectric thin film 300 may have high permittivity and a low dissipation factor of 0.05 or less.

The perovskite material layer 12-1 may include two or more types of Group II elements. Furthermore, like the perovskite material layer 12-1, the rocksalt layer 11-1 may include two or more types of Group II elements. In example embodiments, the perovskite material layer 12-1 and the rocksalt layer 11-1 may include the same kind of two or more types of Group II elements. Furthermore, at the same time, a first content ratio of the two or more types of Group II elements included in the perovskite material layer 12-1 and a second content ratio of the two or more types of Group II elements included in the rocksalt layer 11-1 may be substantially similar and/or identical to each other.

Referring to FIG. 2, the dielectric thin film 310 according to some example embodiments may include the stack structures 10-1, 10-2, 10-3, ... , and 10-n that are sequentially stacked. Though at least four (4) stack structures are illustrated, this is for clarity of illustration and the example embodiments are not limited thereto. For example, n may be a natural number greater than or equal to 2. The stack structures 10-1, 10-2, 10-3, ... , and 10-n may include a plurality of perovskite material layers 12-1, 12-2, 12-3, ... , and 12-n including two or more types of Group II elements and a plurality of rocksalt layers 11-1, 11-2, 11-3, ... , and 11-n including two or more types of Group II elements. For example, the second stack structure 10-2, the third stack structure 10-3, ... , and the n-th stack structure 10-n may be sequentially provided below the first stack structure 10-1.

In these cases, the first stack structure 10-1 may include the first perovskite material layer 12-1 and the first rocksalt layer 11-1 provided on the first perovskite material layer 12-1. The second stack structure 10-2 may include the second perovskite material layer 12-2 and a second rocksalt layer 11-2 provided on the second perovskite material layer 12-2. The third stack structure 10-3 may include the third perovskite material layer 12-3 and the third rocksalt layer 11-3 provided on the third perovskite material layer 12-3. The n-th stack structure 10-n may include the n-th perovskite material layer 12-n and the n-th rocksalt layer 11-n provided on the n-th perovskite material layer 12-n.

The first perovskite material layer 12-1 and the first rocksalt layer 11-1 included in the first stack structure 10-1 may include the same kind of two or more types of Group II elements. The second perovskite material layer 12-2 and the second rocksalt layer 11-2 included in the second stack structure 10-2 may include the same kind of two or more types of Group II elements. The third perovskite material layer 12-3 and the third rocksalt layer 11-3 included in the third stack structure 10-3 may include the same kind of two or more types of Group II elements. The n-th perovskite material layer 12-n and the n-th rocksalt layer 11-n included in the n-th stack structure 10-n may include the same kind of two or more types of Group II elements.

For example, each of the stack structures 10-1, 10-2, 10-3, ... , and 10-n included in the dielectric thin film 310 may include the same kind of two or more types of Group II elements. Furthermore, at the same time, a content ratio of two or more types of Group II elements included in each of the stack structures 10-1, 10-2, 10-3, ... , and 10-n may be identical to each other. For example, a first content ratio of the two or more types of Group II elements included in the first stack structure 10-1, a second content ratio of the two or more types of Group II elements included in the second stack structure 10-2, a third content ratio of the two or more types of Group II elements included in the third stack structure 10-3, and an n-th content ratio of the two or more types of Group II elements included in the n-th stack structure 10-n may be identical to one another.

Referring to FIG. 3, the dielectric thin film 310 may be formed on a substrate sub, and a stripe pattern may be formed in the cross section of the dielectric thin film 310. Such a stripe pattern may be formed in a boundary area where the perovskite material layers 12-1, 12-2, 12-3, ... , and 12-n and the rocksalt layers 11-1, 11-2, 11-3, ... , and 11-n included in the dielectric thin film 310 are in contact with each other.

In the following description, the structure of a material included in the dielectric thin film 300 of FIG. 1 and the dielectric thin film 310 of FIG. 2 is described with reference to FIGS. 4 and 5. Here, the structure of the material included in the dielectric thin film 310 of FIG. 2 is described. The descriptions about the structure of the material included in the dielectric thin film 310 of FIG. 2 is substantially identically applied to the structure of the material included in the dielectric thin film 300 of FIG. 1.

Referring to FIG. 4, each of the perovskite material layers 12-1, 12-2, 12-3, ... , and 12-n of the dielectric thin film 310 may include a perovskite material expressed by a chemical formula "((A, A')BX₃)ₘ". In this case, A and A' refer to different Group II elements, and B refers to a Group IV element. Furthermore, X refers to an oxygen element O. m may represent the number of layers of unit cells and is a natural number greater than or equal to 2. For example, m is a natural number greater than 10. For example, m may be 20. However, the disclosure is not limited thereto, and n may be a natural number less than or greater than 20. The perovskite material denoted by ((A, A')BX₃)ₘ may have a first lattice constant d1.

For example, A may be barium (Ba), A' may be strontium (Sr), and B may be titanium (Ti). However, the example embodiments are not limited thereto, and a combination of A and A' may include a combination of various types of Group II elements other than Ba and Sr. Furthermore, B may include various types of Group IV elements other than Ti.

When A is Ba, A' is Sr, and B is Ti, each of the perovskite material layers 12-1, 12-2, 12-3, ... , and 12-n may include ((Ba, Sr)TiO₃)ₘ. For example, each of the perovskite material layers 12-1, 12-2, 12-3, ... , and 12-n may have a structure in which n material layers including (Ba, Sr)TiO₃ are stacked.

(Ba, Sr)TiO₃ may include a structure in which Ba and Sr are distributed at a certain ratio in a unit cell. For example, (Ba, Sr)TiO₃ may include a structure in which Ba and Sr is distributed at a ratio of 1:1 in a unit cell. For example, when the first perovskite material layer 12-1 includes (Ba, Sr)TiO₃ having a structure in which Ba and Sr are distributed at a ratio of 1:1 in a unit cell, the lattice constant of the first perovskite material layer 12-1 may be about 3.95 Å. However, the disclosure is not limited thereto, and (Ba, Sr)TiO₃ may include a structure in which Ba and Sr are distributed at various ratios other than 1:1 in a unit cell.

For example, as illustrated in FIG. 6, when m is 20, each of the first perovskite material layer 12-1 and the second perovskite material layer 12-2 may include a structure in which twenty (20) material layers including (Ba, Sr)TiO₃ are stacked. Each of the first perovskite material layer 12-1 and the second perovskite material layer 12-2 may include ((Ba, Sr)TiO₃)₂₀. In these cases, each of the first perovskite material layer 12-1 and the second perovskite material layer 12-2 may extend in a direction parallel to a two-dimensional plane (x-y plane). Similarly thereto, each of the other perovskite material layers 12-3, ... , 12-n included in the dielectric thin film 310 may have a structure in which twenty (20) material layers including (Ba, Sr)TiO₃ are stacked.

Furthermore, each of the perovskite material layers 12-1, 12-2, 12-3, ... , and 12-n of the dielectric thin film 310 may include a perovskite material expressed by a chemical formula "((A, A')(B, B')X3)ₘ". In these cases, A and A' are different Group II elements, and B and B' are different Group IV elements. Furthermore, X refers to the oxygen element O. m is a natural number greater than or equal to 2.

Referring to FIG. 5, each of the rocksalt layers 11-1, 11-2, 11-3, ... , and 11-n of the dielectric thin film 310 may include a rocksalt material expressed by a chemical formula "(C, C')X". In this case, C and C' are different Group II elements, and X is the oxygen element O. A rocksalt material indicated by (C, C')X may have a second lattice constant d2. The second lattice constant d2 may be less than the first lattice constant d1 of a perovskite material. For example, C may be Ba, and C' may be Sr. However, the disclosure is not limited thereto, and the combination of C and C' may include a combination of various types of Group II elements other than Ba and Sr.

When C is Ba and C' is Sr, each of the rocksalt layers 11-1, 11-2, 11-3, ... , and 11-n may include (Ba, Sr)O. In these cases, each of the rocksalt layers 11-1, 11-2, 11-3, ... , and 11-n may be formed in a single layer having a thickness of a unit cell scale including (Ba, Sr)O. As such, as each of the rocksalt layers 11-1, 11-2, 11-3, ... , and 11-n is formed in a single layer having a thickness of a unit cell scale, each of the rocksalt layers 11-1, 11-2, 11-3, ... , and 11-n may have no effect on an overall capacitance of the dielectric thin film 310. For example, even when the rocksalt layers 11-1, 11-2, 11-3, ... , and 11-n are inserted between the perovskite material layers 12-1, 12-2, 12-3, ... , and 12-n, compared with a case including the perovskite material layers 12-1, 12-2, 12-3, ... , and 12-n only, the overall capacitance of the dielectric thin film 310 may not be reduced.

(Ba, Sr)O may have a structure in which Ba and Sr are distributed at a certain ration in a unit cell. For example, (Ba, Sr)O may have a structure in which Ba and Sr are distributed at a ratio of 1:1 in a unit cell. For example, when the first rocksalt layer 11-1 includes (Ba, Sr)O having a structure in which Ba and Sr are distributed at a ratio of 1:1 in a unit cell, the lattice constant of the first rocksalt layer 11-1 may be about 3.95 Å. However, the disclosure is not limited thereto, and (Ba, Sr)O may have a structure in which Ba and Sr are distributed at various ratios other than 1:1 in a unit cell.

A included in each of the perovskite material layers 12-1, 12-2, 12-3, ... , and 12-n and C included in each of the rocksalt layers 11-1, 11-2, 11-3, ... , and 11-n may be the same element. Furthermore, A' included in each of the perovskite material layers 12-1, 12-2, 12-3, ... , and 12-n and C' included in each of the rocksalt layers 11-1, 11-2, 11-3, ... , and 11-n may be the same element. For example, A and C may be identically Ba, and A' and C' may be identically Sr. In these cases, a first content ratio A/A' of A to A' and a second content ratio C/C' of C to C' may be identical. For example, the first content ratio A/A' of A to A' and the second content ratio C/C' of C to C' may be identical to each other at various ratios such as 0.5/0.5, 0.2/0.8, 0.3/0.7, 0.4/0.6, and/or the like. However, the disclosure is not limited thereto, and the first content ratio A/A' of A to A' and the second content ratio C/C' of C to C' may include various ratios other than the above listed ratios.

For example, when A and C are identically Ba, and A' and C' are identically Sr, the first content ratio A/A' and the second content ratio C/C' may be identically 0.3 or less. As such, when a ratio of Ba to Sr is maintained as low as 0.3 or less, a Ba segregation phenomenon may be reduced in the perovskite material layers 12-1, 12-2, 12-3, ... , and 12-n and/or the rocksalt layers 11-1, 11-2, 11-3, ... , and 11-n.

When each of the perovskite material layers 12-1, 12-2, 12-3, ... , and 12-n of the dielectric thin film 310 includes a perovskite material expressed by a chemical formula "((A, A')(B, B')X3)m," the first content ratio A/A' of A to A' and the second content ratio C/C' of C to C' may be identical.

In the following description, the structure of an interface between the first perovskite material layer 12-1 and the first rocksalt layer 11-1 is described with reference to FIG. 7 to 9. The descriptions about the structure of the interface between the first perovskite material layer 12-1 and the first rocksalt layer 11-1 may be substantially identically applied to the structure between each of the second to n-th perovskite material layers 12-2, 12-3, ... , and 12-n and each of the second to n-th rocksalt layers 11-2, 11-3, ... , and 11-n.

Referring to FIG. 7, the first perovskite material layer 12-1 may have the first lattice constant d1 as described above with reference to FIG. 4. The first lattice constant d1 may mean the shortest distance between, e.g., two neighboring Group II elements (e.g., among A and A') included in the first perovskite material layer 12-1. Furthermore, the first rocksalt layer 11-1 may have the second lattice constant d2 as described above with reference to FIG. 5. The second lattice constant d2 may mean the shortest distance between, e.g., two neighboring Group II elements (e.g., among C and C') included in the first rocksalt layer 11-1. In these cases, according to a difference in the structural properties of the first perovskite material layer 12-1 and the first rocksalt layer 11-1, the first lattice constant d1 may be greater than the second lattice constant d2. Accordingly, due to the lattice constant difference, strain may be generated at the interface between the first perovskite material layer 12-1 and the first rocksalt layer 11-1. For example, without being limited to a particular theory, lattice mismatch between the first perovskite material layer 12-1 and the first rocksalt layer 11-1 may induce strain at the interface between the first perovskite material layer 12-1 and the first rocksalt layer 11-1.

As illustrated in FIG. 8, the dielectric thin film 310 including the n-th perovskite material layer 12-n and the n-th rocksalt layer 11-n may be formed on an electrode 30, and spontaneous polarization due to strain may be generated at the interface between the n-th perovskite material layer 12-n and the n-th rocksalt layer 11-n. For example, as illustrated in FIG. 9, a spontaneous polarization area SPA where spontaneous polarization occurs may be formed along the interface between the n-th perovskite material layer 12-n and the n-th rocksalt layer 11-n. The spontaneous polarization area SPA may prevent an occurrence of a dielectric loss of the dielectric thin film 310 and/or a dissipation factor of the dielectric thin film 310 may be reduced by the spontaneous polarization area SPA.

The spontaneous polarization area SPA may be formed for each area between each of the perovskite material layers 12-1, 12-2, 12-3, ... , and 12-n and each of the rocksalt layers 11-1, 11-2, 11-3, ... , and 11-n included in the dielectric thin film 310. As such, as the dielectric thin film 310 includes a plurality of stack structures in which each of the rocksalt layers 11-1, 11-2, 11-3, ... , and 11-n is formed on each of the perovskite material layers 12-1, 12-2, 12-3, ... , and 12-n, the dielectric thin film 310 may include a plurality of spontaneous polarization areas SPA. Accordingly, the dissipation factor of the dielectric thin film 310 may be maintained as low as 0.05 or less.

For example, as indicated by a first curve a1 of FIG. 11, for a capacitor employing a dielectric thin film that includes a perovskite material layer without including a rocksalt layer according to a comparative example, as the frequency of an input AC signal increases, the dissipation factor increases as well. Unlike the above, as indicated by a second curve a2 of FIG. 11, for a capacitor employing the dielectric thin film 310 having a structure in which the rocksalt layers 11-1, 11-2, 11-3, ... , and 11-n and the perovskite material layers 12-1, 12-2, 12-3, ... , and 12-n according to an example are alternately stacked, even when the frequency of an input AC signal increases, the dissipation factor may be maintained as low as 0.05 or less.

Furthermore, as show in FIG. 12, for a capacitor employing the dielectric thin film 310 having a structure in which the rocksalt layers 11-1, 11-2, 11-3, ... , and 11-n and the perovskite material layers 12-1, 12-2, 12-3, ... , and 12-n are alternately stacked according to an example, even when the intensity of an input DC signal increases or decreases, a high permittivity of about 700 or more and 1010 or less may be maintained and simultaneously a low dissipation factor of 0.05 or less may be shown.

Referring to FIG. 10, the bandgap energy E1 of each of the rocksalt layers 11-1, 11-2, 11-3, ... , and 11-n included in the dielectric thin film 310 is greater than the bandgap energy E2 of each of the perovskite material layers 12-1, 12-2, 12-3, ... , and 12-n.

Furthermore, the lowest energy level in a conduction band CB1 of each of the rocksalt layers 11-1, 11-2, 11-3, ... , and 11-n is greater than the lowest energy level in a conduction band CB2 of each of the perovskite material layers 12-1, 12-2, 12-3, ... , and 12-n. For example, the lowest energy level in a conduction band CB1 of the first rocksalt layer 11-1 is greater than the lowest energy level in a conduction band CB2 of the first perovskite material layer 12-1. Furthermore, the highest energy level in a valence band VB1 of each of the rocksalt layers 11-1, 11-2, 11-3, ... , and 11-n is greater than the highest energy level in a valence band VB2 of each of the perovskite material layers 12-1, 12-2, 12-3, ... , and 12-n. For example, the highest energy level in a valence band VB1 of the first rocksalt layer 11-1 is greater than the highest energy level in a valence band VB2 of the first perovskite material layer 12-1.

As such, as the lowest energy level in a conduction band of each of the rocksalt layers 11-1, 11-2, 11-3, ... , and 11-n is greater than the lowest energy level in a conduction band of each of the perovskite material layers 12-1, 12-2, 12-3, ... , and 12-n, a leakage current of a capacitor employing the dielectric thin film 310 may be reduced.

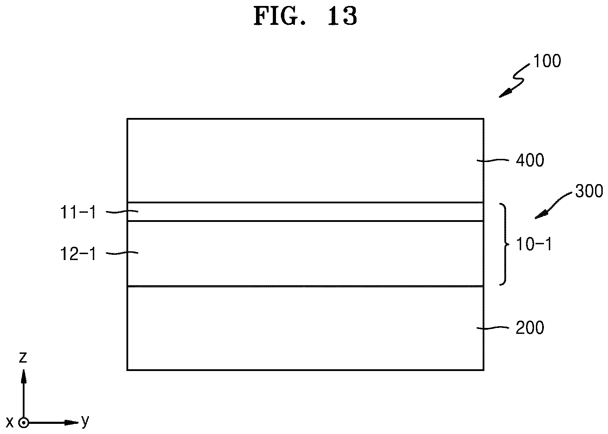

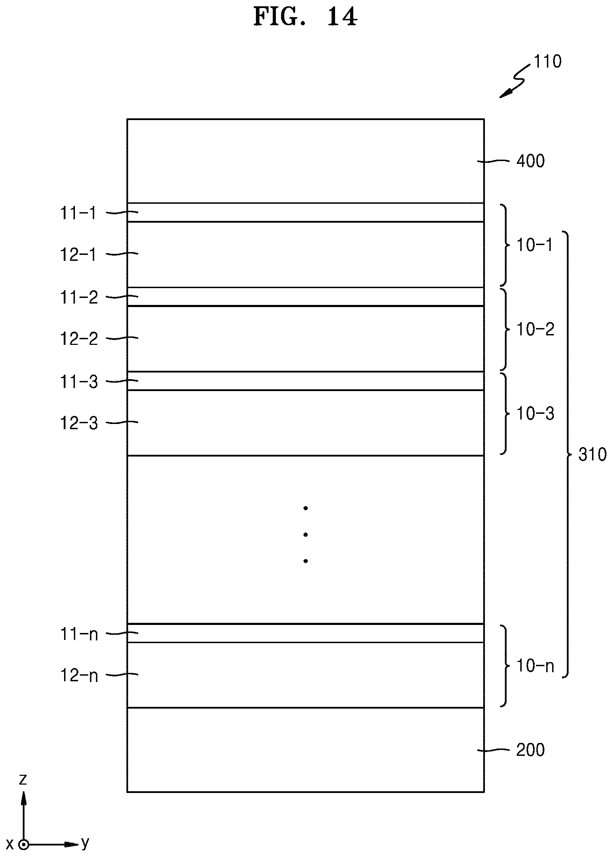

FIG. 13 is a schematic view of an example configuration of a capacitor 100 according to some example embodiments. FIG. 14 is a schematic view of an example configuration of a capacitor 110 according to some example embodiments.

The capacitors 100 and 110 of FIGS. 13 and 14 may each have a metal-insulator-metal (MIM) structure.

Referring to FIG. 13, the capacitor 100 according to some example embodiments may include a lower electrode 200, an upper electrode 400 spaced apart from the lower electrode 200, and the dielectric thin film 300 located between the lower electrode 200 and the upper electrode 400. The dielectric thin film 300 may include the dielectric thin film 300 of FIG. 1 that has the stack structure 10-1 including the perovskite material layer 12-1 and the rocksalt layer 11-1 formed on the perovskite material layer 12-1.

Furthermore, referring to FIG. 14, the capacitor 110 according to some example embodiments may include the lower electrode 200, the upper electrode 400 spaced apart from the lower electrode 200, and the dielectric thin film 310 located between the lower electrode 200 and the upper electrode 400. The dielectric thin film 310 may include the dielectric thin film 310 of FIG. 2 that has the stack structures 10-1, 10-2, 10-3, ... , and 10-n including the perovskite material layers 12-1, 12-2, 12-3, ... , and 12-n and the rocksalt layers 11-1, 11-2, 11-3, ... , and 11-n formed on the perovskite material layers 12-1, 12-2, 12-3, ... , and 12-n.

In some example embodiments, the lower electrode 200 may include a conductive material having a perovskite material. For example, the lower electrode 200 may include at least one of SrVO₃, SrMnO₃, SrCrO₃, SrFeO₃, SrCoO₃, SrRuO₃, SrMoO₃, SrIrO₃, SrNbO₃, SrCoO₃, and/or the like.

When the lower electrode 200 includes SrRuO₃, the lattice constant of the lower electrode 200 may be about 3.93 Å. In some example embodiments, the thickness of the lower electrode 200 may be about 300 Å. However, the disclosure is not limited thereto, and the thickness of the lower electrode 200 may be 300 Å or less.

The upper electrode 400 may include a conductive material having a perovskite material. For example, the upper electrode 400 may include at least one of SrVO₃, SrMnO₃, SrCrO₃, SrFeO₃, SrCoO₃, SrRuO₃, SrMoO₃, SrIrO₃, SrNbO₃, SrCoO₃, and/or the like.

When the upper electrode 400 includes SrRuO₃, the lattice constant of the upper electrode 400 may be about 3.93 Å. In some example embodiments, the thickness of the upper electrode 400 may be about 300 Å. However, the disclosure is not limited thereto, and the thickness of the upper electrode 400 may be 300 Å or less.

Furthermore, a lattice mismatch level between the lower electrode 200 and the dielectric thin film 300 of FIG. 13 (and/or the dielectric thin film 310 of FIG. 14) and/or a lattice mismatch level between the upper electrode 400 and the dielectric thin film 300 of FIG. 13 (and/or the dielectric thin film 310 of FIG. 14) may be 5% or less. For example, the lattice mismatch level between the lower electrode 200 and the dielectric thin film 300 of FIG. 13 or the dielectric thin film 310 of FIG. 14 and the lattice mismatch level between the upper electrode 400 and the dielectric thin film 300 of FIG. 13 or the dielectric thin film 310 of FIG. 14 may be about 0.5%.

As both of the lattice mismatch level between the lower electrode 200 and the dielectric thin film 300 of FIG. 13 and/or the dielectric thin film 310 of FIG. 14 and the lattice mismatch level between the upper electrode 400 and/or the dielectric thin film 300 of FIG. 13 and/or the dielectric thin film 310 of FIG. 14 are maintained as low as 5% or less, the crystallinity of the capacitors 100 and 110 may be maintained.

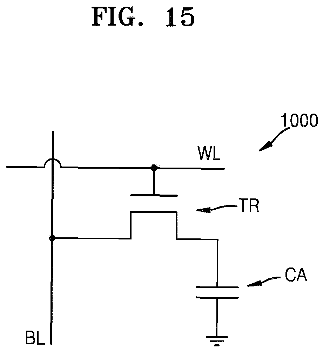

FIG. 15 is a circuit diagram showing a schematic circuit configuration and operation of an electronic device 1000 employing capacitors according to some example embodiments.

A circuit diagram of the electronic device 1000 shows one cell of a dynamic random access memory (DRAM) device, the cell including one transistor TR and one capacitor CA, and a word line WL and a bit line BL. The capacitor CA may be the capacitors 100 and 110 that are described above with reference to FIGS. 13 and 14.

A method of writing data to DRAM is described as follows. A gate voltage (high) to make the transistor TR in an "ON" state is applied to a gate electrode through the word line WL, and then, a data voltage value of VDD (high) or 0 (low) is applied to the transistor TR through the bit line BL. When high voltages are applied through the word line WL and the bit line BL, the capacitor CA is charged and data "1" is written, and when a high voltage is applied through the word line WL and a low voltage is applied through the bit line BL, the capacitor CA is discharged and data "0" is written.

In order to read data, a high voltage is applied through the word line WL to turn on the transistor TR of DRAM, and then, a voltage of VDD/2 is applied through the bit line BL. When the data of DRAM is "1," that is, the voltage of the capacitor CA is VDD, charges in the capacitor CA gradually flows toward the bit line BL and the voltage of the bit line BL becomes slightly higher than VDD/2. Reversely, when the data of the capacitor CA is "0," charges of the bit line BL flows toward the capacitor CA so that the voltage of the bit line BL becomes slightly lower than VDD/2. A sense amplifier may detect a potential difference generated in the bit line BL as above and amplify a value to determine whether the data is "0" or "1."

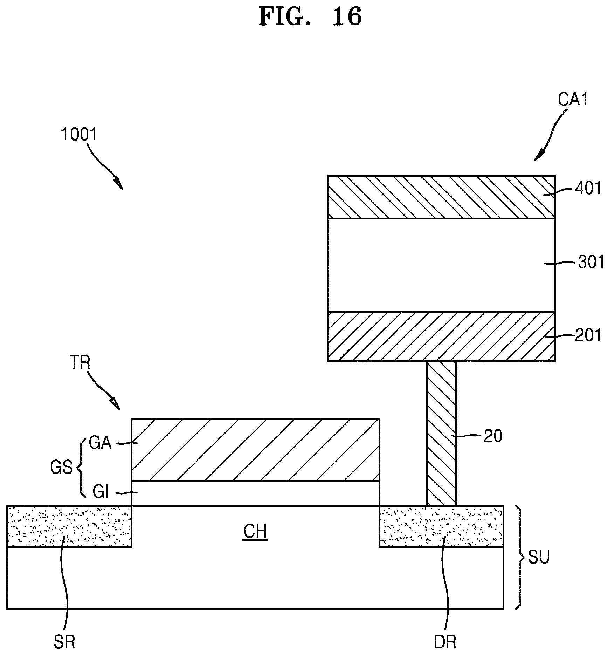

FIG. 16 is a schematic view of an electronic device 1001 according to an embodiment.

Referring to FIG. 16, the electronic device 1001 may have a structure in which a capacitor CA1 and the transistor TR are electrically connected to each other by a contact 20. The capacitor CA1 may include a lower electrode 201, an upper electrode 401, and a dielectric thin film 301 provided between the lower electrode 201 and the upper electrode 401. The capacitor CA1 may be the capacitors 100 and 110 that are described above with reference to FIGS. 13 and 14. In these cases, the dielectric thin film 301 may correspond to the dielectric thin film 300 of FIG. 1 or the dielectric thin film 310 of FIG. 2.

The transistor TR may be an electric field effect transistor. The transistor TR may include a semiconductor substrate SU including a source region SR, a drain region DR, and a channel region CH, and a gate stack GS disposed on the semiconductor substrate SU to face the channel region CH and including a gate insulating layer GI and a gate electrode GA.

The channel region CH is an area between the source region SR and the drain region DR, and is electrically connected to the source region SR and the drain region DR. The source region SR may be electrically connected to or may contact one side end portion of the channel region CH, and the drain region DR may be electrically connected to or may contact the other side end portion of the channel region CH. The channel region CH may be defined as a substrate area between the source region SR and the drain region DR in the semiconductor substrate SU.

The semiconductor substrate SU may include a semiconductor material. The semiconductor substrate SU may include, for example, a semiconductor material such as silicon (Si), germanium (Ge), silicon germanium (SiGe), silicon carbide (SiC), gallium arsenic (GaAs), indium arsenic (InAs), indium phosphide (InP), molybdenum disulfide (MoS₂), and/or the like. Furthermore, the semiconductor substrate SU may include a silicon-on-insulator (SOI) substrate.

The source region SR, the drain region DR, and the channel region CH may each be formed by independently injecting impurities into different areas of the semiconductor substrate SU, and in these cases, the source region SR, the channel region CH, and the drain region DR may include a substrate material as a base material. The source region SR and the drain region DR may include and/or be formed of a conductive material, and in these cases, the source region SR and the drain region DR may include, for example, a metal, a metal compound, and/or a conductive polymer.

The channel region CH, unlike the illustration, may be implemented as a separate material layer (thin film). In this case, for example, the channel region CH may include at least one of Si, Ge, SiGe, a group III-V semiconductor, an oxide semiconductor, a nitride semiconductor, an oxynitride semiconductor, a two-dimensional (2D) material, a quantum dot, an organic semiconductor, and/or the like. For example, the oxide semiconductor may include InGaZnO and/or the like, and the 2D material may include transition metal dichalcogenide (TMD) and/or graphene, and the quantum dot may include a colloidal quantum dot (QD) and/or nanocrystal structure.

The gate electrode GA may be disposed on the semiconductor substrate SU apart from the semiconductor substrate SU to face the channel region CH. The gate electrode GA may include at least one of a metal, a metal nitride, a metal carbide, or polysilicon. For example, the metal may include at least one of aluminum (Al), tungsten (W), molybdenum (Mo), Ti, tantalum (Ta), and/or the like; the metal nitride film may include at least one of a titanium nitride (TiN) film, a tantalum nitride (TaN) film, and/or the like; the metal carbide may include at least one of metal carbide doped with or containing Al and Si, and as a detailed example, may include at least one of TiAlC, TaAlC, TiSiC, and/or TaSiC.

The gate electrode GA may have a stack structure of a plurality of materials, for example, a stack structure of a metal nitride layer / a metal layer such as TiN/Al (and/or the like), and/or a stack structure of a metal nitride layer / a metal carbide layer / a metal layer such as TiN/TiAlC/W. However, the materials mentioned below are merely exemplary.

The gate insulating layer GI may be further disposed between the semiconductor substrate SU and the gate electrode GA. The gate insulating layer GI may include a paraelectric material and/or a high-k dielectric material, and may have a dielectric constant of about 20 to 70.

The gate insulating layer GI may include, for example, at least one of a silicon oxide (SiO₂), a silicon nitride (SiNx), an aluminum oxide (Al₂O₃), a hafnium oxide (HfO₂), a zirconium oxide (ZrO₂), a 2D insulator such as hexagonal boron nitride (h-BN), and/or the like. For example, the gate insulating layer GI may include SiO₂, SiNx, and the like, and may include HfO₂, a hafnium silicon oxide (HfSiO₄), a lanthanum oxide (La₂O₃), a lanthanum aluminum oxide (LaAlO₃), ZrO₂, a hafnium zirconium oxide (HfZrO₂), a zirconium silicon oxide (ZrSiO₄), a tantalum oxide (Ta₂O₅), a titanium oxide (TiO₂), a strontium titanium oxide (SrTiO₃), a yttrium oxide (Y₂O₃), Al₂O₃, a red scandium tantalum oxide (PbSc_{0.5}Ta_{0.5}O₃), red zinc niobate (PbZnNbO₃), and/or the like. Furthermore, the gate insulating layer GI may include a metal oxynitride such as an aluminum oxynitride (AlON), a zirconium oxynitride (ZrON), a hafnium oxynitride (HfON), a lanthanum oxynitride (LaON), an yttrium oxynitride (YON), and the like, a silicate such as ZrSiON, HfSiON, YSiON, LaSiON, and/or the like, or an aluminate such as ZrAlON, HfAlON, and/or the like. The gate insulating layer GI may form a gate stack with the gate electrode GA.

One of the electrodes 201 and 401 of the capacitor CA1 and one of the source region SR and the drain region DR of the transistor TR may be electrically connected to each other by the contact 20. Here, the contact 20 may include an appropriate conductive material, for example, W, copper, Al, polysilicon, and/or the like. In some example embodiments, the contact 20 may be omitted and the one of the electrodes 201 and 401 of the capacitor CA1 and the one of the source region SR and the drain region DR of the transistor TR may directly contact each other.

The arrangement of the capacitor CA1 and the transistor TR may be changed in various ways. For example, the capacitor CA1 may be disposed on the semiconductor substrate SU, or may be embedded in the semiconductor substrate SU.

Although FIG. 16 illustrates that the electronic device 1001 includes one capacitor and one transistor, the example embodiments are not limited thereto, and the electronic device 1001 may include a plurality of capacitors and a plurality of transistors.

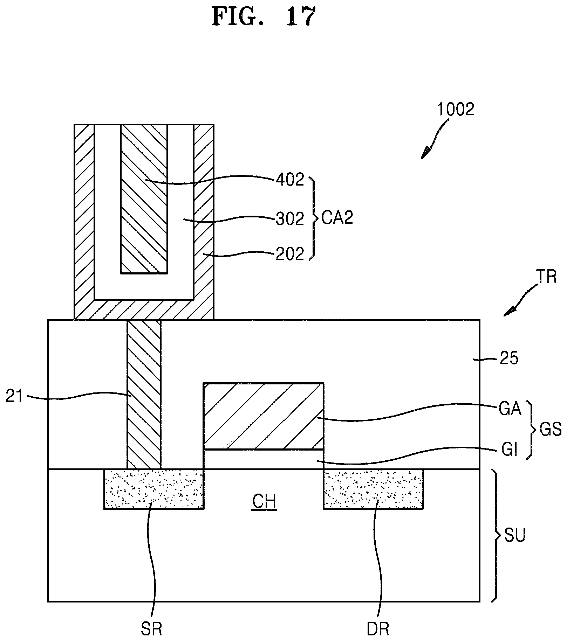

FIG. 17 is a schematic view of an electronic device 1002 according some example embodiments.

Referring to FIG. 17, the electronic device 1002 may have a structure in which a capacitor CA2 and the transistor TR are electrically connected to each other by a contact 210. The capacitor CA2 may include a lower electrode 202, an upper electrode 402, and a dielectric thin film 302 provided between the lower electrode 202 and the upper electrode 402.

The transistor TR may include the semiconductor substrate SU including the source region SR, the drain region DR, and the channel region CH, and the gate stack GS disposed on the semiconductor substrate SU to face the channel region CH and including the gate insulating layer GI and the gate electrode GA.

An interlayer insulating film 25 may be provided on the semiconductor substrate SU to cover the gate stack GS. The interlayer insulating film 25 may include an insulating material. For example, the interlayer insulating film 25 may include a Si oxide, for example, SiO₂, an Al oxide, for example, Al₂O₃, and/or a high-k dielectric material, for example, HfO₂. The contact 21 penetrates the interlayer insulating film 25 to electrically connect the transistor TR to the capacitor CA2.

The lower electrode 202 and the upper electrode 402 are provided in a shape to increase a contact area with the dielectric thin film 302. The capacitor CA2 may be the capacitors 100 and 110 that are described above with reference to FIGS. 13 and 14. In these case, the dielectric thin film 302 may correspond to the dielectric thin film 300 of FIG. 1 and/or the dielectric thin film 310 of FIG. 2.

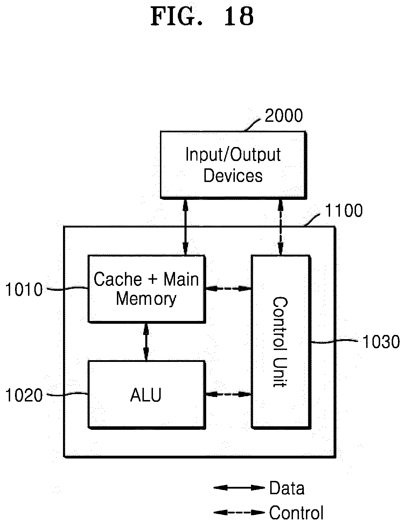

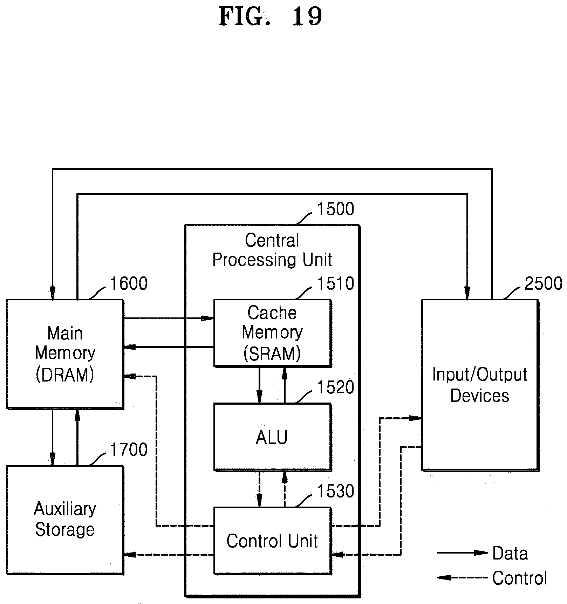

FIGS. 18 and 19 are schematic block diagrams showing the concept of an electronic device architecture 1100 to be applied to an apparatus, according to an embodiment.

Referring to FIG. 18, the electronic device architecture 1100 may include a memory unit 1010, an arithmetic logic unit (ALU) 1020, and a control unit 1030. The memory unit 1010, the ALU 1020, and the control unit 1030 may be electrically connected to one another. For example, the electronic device architecture 1100 may be implemented as one chip including the memory unit 1010, the ALU 1020, and the control unit 1030.

The memory unit 1010, the ALU 1020, and the control unit 1030 are connected on chip to one another by a metal line to directly communicate with one another. The memory unit 1010, the ALU 1020, and the control unit 1030 may be monolithically integrated on one substrate to form one chip. An input/output device 2000 may be connected to the electronic device architecture (chip) 1100. Furthermore, the memory unit 1010 may include both of a main memory and a cache memory. The electronic device architecture (chip) 1100 may be an on-chip memory processing unit. The memory unit 1010 may include the capacitors 100 and 110 described above with reference to FIGS. 13 and 14, and the electronic devices 1001 and 1002 described above with reference to FIGS. 16 and 17. The ALU 1020 or the control unit 1030 may each include the capacitors 100 and 110 described above with reference to FIGS. 13 and 14, and the electronic devices 1001 and 1002 described above with reference to FIGS. 16 and 17.

Referring to FIG. 19, a cache memory 1510, an ALU 1520, and a control unit 1530 may constitute a central processing unit (CPU) 1500, and the cache memory 1510 may be formed of static random access memory (SRAM). Aside from the CPU 1500, a main memory 1600 and an auxiliary storage 1700 may be provided. The main memory 1600 may be dynamic random access memory (DRAM), and may include the capacitors 100 and 110 described above with reference to FIGS. 13 and 14. In some cases, the electronic device architecture may be implemented in the form such that, regardless of sub-units, in one chip, computing unit elements and memory unit elements are adjacent to each other.

According to various embodiments of the disclosure, provided are a dielectric thin film comprising a perovskite material having a low dissipation factor and having a low dielectric loss, a capacitor comprising the dielectric thin film, and an electronic device comprising the capacitor.

According to various embodiments of the disclosure, provided are a dielectric thin film comprising a perovskite material having a low dielectric loss by having a stack structure in which a rocksalt layer is formed on a perovskite material layer, a capacitor comprising the dielectric thin film, and an electronic device comprising the capacitor.

In this disclosure, except when expressly indicated otherwise, the functional blocks that denote elements that process (and/or perform) at least one function or operation may be included in and/or implemented as (and/or in) processing circuitry such hardware, software, or the combination of hardware and software. For example, the processing circuitry more specifically may include (and/or be included in), but is not limited to, a processor (and/or processors), Central Processing Unit (CPU), a controller, an arithmetic logic unit (ALU), a digital signal processor, a microcomputer, a field programmable gate array (FPGA), a System-on-Chip (SoC), a programmable logic unit, a microprocessor, application-specific integrated circuit (ASIC), etc.

According to various embodiments of the disclosure, by repeatedly stacking a stack structure in which a rocksalt layer is formed on a perovskite material layer, the dissipation factor of a dielectric thin film may be further reduced. In these cases, by a structure in which a perovskite material layer having relatively low bandgap energy overlaps a rocksalt layer having a relatively large bandgap energy, a leakage current that can be generated in a dielectric thin film may be reduced.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

## Claims

1. A dielectric thin film (300) comprising:
a stack structure (10-1) including
a perovskite material layer (12-1) including at least two Group II elements, and
a rocksalt layer (11-1) on the perovskite material layer and including at least two Group II elements,
**characterised in that** a first content ratio of the at least two Group II elements included in the perovskite material layer is the same as a second content ratio of the at least two Group II elements included in the rocksalt layer.

2. The dielectric thin film (300) of claim 1, wherein a lowest energy level in a conduction band of the rocksalt layer (11-1) is greater than a lowest energy level in a conduction band of the perovskite material layer (12-1).

3. The dielectric thin film (300) of any one of the preceding claims, wherein the rocksalt layer (11-1) has a thickness of a rocksalt crystal structure unit cell.

4. The dielectric thin film (300) of any one of the preceding claims, wherein
the perovskite material layer (12-1) comprises a material expressed by a chemical formula ((A, A')BX₃)ₘ, in which A and A' are different Group II elements, B is a Group IV element, X is an oxygen element O, and m is a natural number, and
the rocksalt layer (11-1) comprises a material expressed by a chemical formula (C, C')X, in which C and C' are different Group II elements,
and optionally wherein m is a natural number greater than or equal to 2.

5. The dielectric thin film (300) of claim 4, wherein
A and C are the same Group II element,
A' and C' are the same Group II element, and
the first content ratio is represented by A/A' and the second content ratio is represented by C/C'.

6. The dielectric thin film (300) of any one of the preceding claims, further comprising a plurality of the stack structure (10-1) and optionally wherein the plurality of stack structures are sequentially stacked such that the perovskite material layers (12-1) and the rocksalt layers (11-1) alternate.

7. The dielectric thin film (300) of any one of the preceding claims,
wherein
the perovskite material layer (12-1) includes a first lattice constant,
the rocksalt layer (11-1) includes a second lattice constant, and
the first lattice constant is greater than the second lattice constant.

8. A capacitor (100) comprising:
a lower electrode (200);
an upper electrode (400); and
the dielectric thin film (300) of any one of the preceding claims isolating the upper electrode from the lower electrode.

9. The capacitor (100) of claim 8, wherein
the perovskite material layer (12-1) comprises a material expressed by a chemical formula ((A, A')BX₃)ₘ, in which A and A' are different Group II elements, B is a Group IV element, X is an oxygen element O, and m is a natural number, and
the rocksalt layer (11-1) comprises a material expressed by a chemical formula (C, C')X, in which C and C' are different Group II elements,
and optionally wherein m is a natural number greater than or equal to 2.

10. The capacitor (100) of claim 9, wherein
A and C are the same Group II element,
A' and C' are the same Group II element, and
the first content ratio is represented by A/A' and the second content ratio is represented by C/C'.

11. The capacitor (100) of any one of claims 8 to 10, wherein the rocksalt layer (11-1) has a thickness of a rocksalt crystal structure unit cell.

12. The capacitor (100) of any one of claims 8 to 11, wherein at least one the lower electrode (200) or the upper electrode (400) comprises at least one of SrVO₃, SrMnO₃, SrCrO₃, SrFeO₃, SrCoO₃, SrRuO₃, SrMoO₃, SrIrO₃, SrNbO₃, or SrCoO₃.

13. An electronic device (1000) comprising:
a transistor (TR); and
the capacitor (100) of any one of claims 8 to 12 electrically connected to the transistor.

14. The electronic device (1000) of claim 13, wherein the transistor (TR) comprises:
a semiconductor substrate (SU) comprising a source region (SR), a drain region (DR), and a channel region (CH) between the source region and the drain region; and
a gate stack (GS) comprising a gate electrode (GA) on the channel region and a gate insulating layer (GI) isolating the gate electrode from the channel region.

## Patentansprüche

1. Dielektrischer Dünnfilm (300), umfassend:
eine Stapelstruktur (10-1), beinhaltend
eine Perowskitmaterialschicht (12-1), die zumindest zwei Gruppe-II-Elemente beinhaltet,
und
eine Steinsalzschicht (11-1) auf der Perowskitmaterialschicht und zumindest zwei Gruppe-II-Elemente beinhaltend,
**dadurch gekennzeichnet, dass**
ein erstes Gehaltsverhältnis der zumindest zwei Gruppe-II-Elemente, die in der Perowskitmaterialschicht beinhaltet sind, dasselbe wie ein zweites Gehaltsverhältnis der zumindest zwei Gruppe-II-Elemente ist, die in der Steinsalzschicht beinhaltet sind.

2. Dielektrischer Dünnfilm (300) nach Anspruch 1, wobei ein niedrigstes Energieniveau in einem Leitungsband der Steinsalzschicht (11-1) größer als ein niedrigstes Energieniveau in einem Leitungsband der Perowskitmaterialschicht (12-1) ist.

3. Dielektrischer Dünnfilm (300) nach einem der vorhergehenden Ansprüche, wobei die Steinsalzschicht (11-1) eine Dicke einer Steinsalzkristallstruktureinheitszelle aufweist.

4. Dielektrischer Dünnfilm (300) nach einem der vorhergehenden Ansprüche, wobei
die Perowskitmaterialschicht (12-1) ein Material umfasst, das durch eine chemische Formel ((A, A')BX₃)ₘ ausgedrückt ist, in der A und A' unterschiedliche Gruppe-II-Elemente sind, B ein Gruppe-IV-Element ist, X ein Sauerstoffelement O ist und m eine natürliche Zahl ist, und
die Steinsalzschicht (11-1) ein Material umfasst, das durch eine chemische Formel (C, C')X ausgedrückt ist, in der C und C' unterschiedliche Gruppe-II-Elemente sind,
und wobei optional m eine natürliche Zahl größer als oder gleich 2 ist.

5. Dielektrischer Dünnfilm (300) nach Anspruch 4, wobei
A und C dasselbe Gruppe-II-Element sind,
A' und C' dasselbe Gruppe-II-Element sind und
das erste Gehaltsverhältnis durch A/A' dargestellt ist und das zweite Gehaltsverhältnis durch C/C' dargestellt ist.

6. Dielektrischer Dünnfilm (300) nach einem der vorhergehenden Ansprüche, ferner umfassend eine Vielzahl der Stapelstruktur (10-1) und wobei optional die Vielzahl von Stapelstrukturen sequentiell gestapelt ist, sodass sich die Perowskitmaterialschichten (12-1) und die Steinsalzschichten (11-1) abwechseln.

7. Dielektrischer Dünnfilm (300) nach einem der vorhergehenden Ansprüche, wobei
die Perowskitmaterialschicht (12-1) eine erste Gitterkonstante beinhaltet,
die Steinsalzschicht (11-1) eine zweite Gitterkonstante beinhaltet und
die erste Gitterkonstante größer als die zweite Gitterkonstante ist.

8. Kondensator (100), umfassend:
eine untere Elektrode (200);
eine obere Elektrode (400); und
den dielektrischen Dünnfilm (300) nach einem der vorhergehenden Ansprüche, der die obere Elektrode von der unteren Elektrode isoliert.

9. Kondensator (100) nach Anspruch 8, wobei
die Perowskitmaterialschicht (12-1) ein Material umfasst, das durch eine chemische Formel ((A, A')BX₃)ₘ ausgedrückt ist, in der A und A' unterschiedliche Gruppe-II-Elemente sind, B ein Gruppe-IV-Element ist, X ein Sauerstoffelement O ist und m eine natürliche Zahl ist, und
die Steinsalzschicht (11-1) ein Material umfasst, das durch eine chemische Formel (C, C')X ausgedrückt ist, in der C und C' unterschiedliche Gruppe-II-Elemente sind,
und wobei optional m eine natürliche Zahl größer als oder gleich 2 ist.

10. Kondensator (100) nach Anspruch 9, wobei
A und C dasselbe Gruppe-II-Element sind,
A' und C' dasselbe Gruppe-II-Element sind und
das erste Gehaltsverhältnis durch A/A' dargestellt ist und das zweite Gehaltsverhältnis durch C/C' dargestellt ist.

11. Kondensator (100) nach einem der Ansprüche 8 bis 10, wobei die Steinsalzschicht (11-1) eine Dicke einer Steinsalzkristallstruktureinheitszelle aufweist.

12. Kondensator (100) nach einem der Ansprüche 8 bis 11, wobei zumindest eine von der unteren Elektrode (200) oder der oberen Elektrode (400) zumindest eines von SrVO₃, SrMnO₃, SrCrO₃, SrFeO₃, SrCoO₃, SrRuO₃, SrMoO₃, SrIrO₃, SrNbO₃ oder SrCoO₃ umfasst.

13. Elektronische Vorrichtung (1000), umfassend:
einen Transistor (TR); und
den Kondensator (100) nach einem der Ansprüche 8 bis 12, der elektrisch mit dem Transistor verbunden ist.

14. Elektronische Vorrichtung (1000) nach Anspruch 13,
wobei der Transistor (TR) Folgendes umfasst:
ein Halbleitersubstrat (SU), das eine Source-Region (SR), eine Drain-Region (DR) und eine Kanalregion (CH) zwischen der Source-Region und der Drain-Region umfasst; und
einen Gate-Stapel (GS), der eine Gate-Elektrode (GA) auf der Kanalregion und eine Gate-Isolierschicht (GI) umfasst, welche die Gate-Elektrode von der Kanalregion isoliert.

## Revendications

1. Film mince diélectrique (300) comprenant :
une structure d'empilement (10-1) comprenant
une couche de matériau pérovskite (12-1) comprenant au moins deux éléments du groupe II, et
une couche de sel gemme (11-1) sur la couche de matériau pérovskite et comprenant au moins deux éléments du groupe II,
**caractérisé en ce qu'**un premier rapport de teneur des au moins deux éléments du groupe II compris dans la couche de matériau pérovskite est le même qu'un second rapport de teneur des au moins deux éléments du groupe II compris dans la couche de sel gemme.

2. Film mince diélectrique (300) de la revendication 1,
dans lequel un niveau d'énergie le plus bas dans une bande de conduction de la couche de sel gemme (11-1) est supérieur à un niveau d'énergie le plus bas dans une bande de conduction de la couche de matériau pérovskite (12-1).

3. Film mince diélectrique (300) de l'une quelconque des revendications précédentes, dans lequel la couche de sel gemme (11-1) présente une épaisseur d'une cellule unitaire de structure cristalline de sel gemme.

4. Film mince diélectrique (300) de l'une quelconque des revendications précédentes, dans lequel
la couche de matériau pérovskite (12-1) comprend un matériau exprimé par une formule chimique ((A, A')BX₃)ₘ, où A et A' sont des éléments différents du groupe II, B est un élément du groupe IV, X est un élément oxygène O, et m est un nombre naturel, et
la couche de sel gemme (11-1) comprend un matériau exprimé par une formule chimique (C, C')X, où C et C' sont des éléments différents du groupe II,
et éventuellement dans lequel m est un nombre naturel supérieur ou égal à 2.

5. Film mince diélectrique (300) de la revendication 4, dans lequel
A et C sont le même élément du groupe II,
A' et C' sont le même élément du groupe II, et
le premier rapport de teneur est représenté par A/A' et le second rapport de contenu est représenté par C/C'.

6. Film mince diélectrique (300) de l'une quelconque des revendications précédentes, comprenant en outre une pluralité de la structure d'empilement (10-1) et éventuellement dans lequel la pluralité de structures d'empilement sont empilées séquentiellement de sorte que les couches de matériau pérovskite (12-1) et les couches de sel gemme (11-1) alternent.

7. Film mince diélectrique (300) de l'une quelconque des revendications précédentes, dans lequel
la couche de matériau pérovskite (12-1) comprend une première constante de réseau,
la couche de sel gemme (11-1) comprend une seconde constante de réseau, et
la première constante de réseau est supérieure à la seconde constante de réseau.

8. Condensateur (100) comprenant :
une électrode inférieure (200) ;
une électrode supérieure (400) ; et
le film mince diélectrique (300) de l'une quelconque des revendications précédentes isolant l'électrode supérieure de l'électrode inférieure.

9. Condensateur (100) de la revendication 8, dans lequel
la couche de matériau pérovskite (12-1) comprend un matériau exprimé par une formule chimique ((A, A')BX₃)ₘ, où A et A' sont des éléments différents du groupe II, B est un élément du groupe IV, X est un élément oxygène O, et m est un nombre naturel, et
la couche de sel gemme (11-1) comprend un matériau exprimé par une formule chimique (C, C')X, où C et C' sont des éléments différents du groupe II,
et éventuellement dans lequel m est un nombre naturel supérieur ou égal à 2.

10. Condensateur (100) de la revendication 9, dans lequel
A et C sont le même élément du groupe II,
A' et C' sont le même élément du groupe II, et
le premier rapport de teneur est représenté par A/A' et le second rapport de contenu est représenté par C/C'.

11. Condensateur (100) de l'une quelconque des revendications 8 à 10,
dans lequel la couche de sel gemme (11-1) présente une épaisseur d'une cellule unitaire de structure cristalline de sel gemme.

12. Condensateur (100) de l'une quelconque des revendications 8 à 11, dans lequel au moins l'une de l'électrode inférieure (200) ou de l'électrode supérieure (400) comprend au moins l'un parmi SrVO₃, SrMnO₃, SrCrO₃, SrFeO₃, SrCoO₃, SrRuO₃, SrMoO₃, SrlrO₃, SrNbO₃, ou SrCoO₃.

13. Dispositif électronique (1000) comprenant :
un transistor (TR) ; et
le condensateur (100) de l'une quelconque des revendications 8 à 12 connecté électriquement au transistor.

14. Dispositif électronique (1000) de la revendication 13,
dans lequel le transistor (TR) comprend :
un substrat semi-conducteur (SU) comprenant une région de source (SR), une région de drain (DR) et une région de canal (CH) entre la région de source et la région de drain ; et
un empilement de grille (GS) comprenant une électrode de grille (GA) sur la région de canal et une couche isolante de grille (GI) isolant l'électrode de grille de la région de canal.
